# EUROPÄISCHE PATENTANMELDUNG

(11) **EP 4 296 802 A1**
(43) Veröffentlichungstag der Anmeldung: **27.12.2023**
(21) Anmeldenummer: 22180170.7
(22) Anmeldetag: 21.06.2022
(51) Int. Cl.: G05B 19/042, G05B 19/05, G06F 8/30, G06F 30/27

(54) **VERFAHREN UND SYSTEM ZUR ERZEUGUNG VON STEUERUNGS- ODER REGELUNGSPROGRAMMEN FÜR INDUSTRIELLE AUTOMATISIERUNGSGERÄTE**

(71) Anmelder: Siemens Aktiengesellschaft, 80333 München (DE)
(72) Erfinder: Dürr, Matthias, 90473 Nürnberg (DE)
(74) Vertreter: Siemens Patent Attorneys

(57) **Zusammenfassung**

Zur Erzeugung von Steuerungs- oder Regelungsprogrammen für industrielle Automatisierungsgeräte wird auf Basis einer Spezifikation eines mittels zumindest eines Automatisierungsgeräts zu steuernden oder regelnden technischen Prozesses und auf Basis von vorgegebenen Randbedingungen zur Steuerung oder Regelung des technischen Prozesses mittels eines künstlichen neuronalen Generator-Netzwerks (301) ein Entwurf für ein Steuerungsmodell erzeugt (133, 202), dessen Steuerungselemente einer analytisch beschreibbaren, vorgegebenen Verteilung bzw. Zusammensetzung entsprechen. Der erzeugte Entwurf wird mittels eines künstlichen neuronalen Diskriminator-Netzwerks (302) auf Übereinstimmung der Steuerungselemente mit der vorgegebenen Verteilung bzw. Zusammensetzung bewertet. Außerdem wird der Entwurf iterativ entsprechend der Übereinstimmung der Steuerungselemente mit der vorgegebenen Verteilung bzw. Zusammensetzung angepasst und erneut bewertet (134, 204). Auf eine Benutzerfreigabe des Entwurfs wird ein das Steuerungsmodell implementierendes Steuerungs- oder Regelungsprogramm erzeugt (135, 206).

## Beschreibung

Die vorliegende Erfindung betrifft ein Verfahren zur Erzeugung von Steuerungs- oder Regelungsprogrammen für industrielle Automatisierungsgeräte und ein System zur Durchführung dieses Verfahrens.

Industrielle Automatisierungssysteme umfassen üblicherweise eine Vielzahl von über ein industrielles Kommunikationsnetz miteinander vernetzten Automatisierungsgeräten und dienen im Rahmen einer Fertigungs- oder Prozessautomatisierung zur Steuerung oder Regelung von Anlagen, Maschinen bzw. Geräten. Aufgrund zeitkritischer Rahmenbedingungen in industriellen Automatisierungssystemen werden zur Kommunikation zwischen Automatisierungsgeräten überwiegend Echtzeit-Kommunikationsprotokolle, wie PROFINET, PROFIBUS, Real-Time-Ethernet oder Time-Sensitive Networking (TSN), verwendet. Insbesondere können Steuerungsdienste bzw. -anwendungen automatisiert und auslastungsabhängig auf aktuell verfügbare Server oder virtuelle Maschinen eines industriellen Automatisierungssystems verteilt werden.

In WO 2021/034539 A1 ist ein Engineering-System mit mehreren Modulen und einem Prozessor zum Ausführen der Module beschrieben, bei dem die Module ein Lernmodul umfassen, das Quellcode für speicherprogrammierbare Steuerungen (SPS) lernt und Codeeinbettungen für SPS-Quellcode erzeugt. Die Codeeinbettungen definieren Code Snippets für SPS-Quellcode als räumliche Vektoren basierend auf gelerntem SPS-Quellcode. Außerdem ist ein Code-Klassifizierungsmodul dafür vorgesehen, vom Lernmodul empfangene Codeeinbettungen zu verarbeiten und den jeweiligen Code Snippets eine Kategorie zuzuordnen.

Aus WO 2021/040727 A1 ist ein Verfahren zur automatischen Codeerzeugung für speicherprogrammierbare Steuerungen bekannt, bei dem ein Knowledge Graph, der eine Domänen-Ontologie umfasst, sowie Spezifikationen einer Entwicklungsumgebung für eine speicherprogrammierbare Steuerung mittels eines Prozessors verarbeitet werden. Der Knowledge Graph wird anhand der Entwicklungsumgebung durch den Prozessor aktualisiert. Außerdem werden mittels des Prozessors im Knowledge Graph Verknüpfungen zwischen der Domänen-Ontologie und der Entwicklungsumgebung erzeugt. Dabei basieren die Verknüpfungen auf den Spezifikationen der Entwicklungsumgebung und der Domänen-Ontologie. Basierend auf den Verknüpfungen, dem Knowledge Graph und den Spezifikationen der Entwicklungsumgebung wird durch den Prozessor ein für die Entwicklungsumgebung spezifischer Ziel-Code erzeugt.

Einer Anwendung von künstlicher Intelligenz (KI) zur Entwicklung von Steuerungsanwendungen für speicherprogrammierbare Steuerungen steht ein Mangel an Transparenz, Validierbarkeit und Determinismus entgegen, der für auf diese Weise erzeugte Steuerungsanwendungen typisch ist. Durch fehlerhafte Steuerungsanwendungen für industrielle Automatisierungssysteme können insbesondere erhebliche Gefährdungen für Menschen und Umwelt sowie Beschädigungen von Ausrüstungsgegenständen verursacht werden. Aus diesem Grund sind Transparenz und Determinismus bei Steuerungsanwendungen für industrielle Automatisierungssysteme von entscheidender Bedeutung.

Der vorliegenden Erfindung liegt daher die Aufgabe zugrunde, ein Verfahren zur automatisierten Generierung von Steuerungs- bzw. Regelungsprogrammen für industrielle Automatisierungsgeräte zu schaffen, die sich mit vertretbarem Aufwand durch Bedienpersonal validieren bzw. interpretieren lassen, sowie eine geeignete Realisierung zur Durchführung des Verfahrens anzugeben.

Diese Aufgabe wird erfindungsgemäß durch ein Verfahren mit den in Anspruch 1 angegebenen Merkmalen und durch ein System mit den in Anspruch 13 angegebenen Merkmalen gelöst. Vorteilhafte Weiterbildungen der vorliegenden Erfindung sind in den abhängigen Ansprüchen angegeben.

Entsprechend dem erfindungsgemäßen Verfahren zur Erzeugung von Steuerungs- oder Regelungsprogrammen für industrielle Automatisierungsgeräte wird auf Basis einer Spezifikation eines mittels zumindest eines Automatisierungsgeräts zu steuernden oder regelnden technischen Prozesses und auf Basis von vorgegebenen Randbedingungen zur Steuerung oder Regelung des technischen Prozesses mittels eines künstlichen neuronalen Generator-Netzwerks ein Entwurf für ein Steuerungsmodell erzeugt. Dabei entsprechen Steuerungselemente des Steuerungsmodells einer analytisch beschreibbaren, vorgegebenen Verteilung bzw. Zusammensetzung.

Die Spezifikation des zu steuernden bzw. regelnden technischen Prozesses umfasst vorzugsweise ein Prozessmodell. Darüber hinaus umfassen die vorgegebenen Randbedingungen zur Steuerung bzw. Regelung des technischen Prozesses insbesondere Prozesseingangsgrößen, Prozessausgangsgrößen und ein gewünschtes Steuerungs- bzw. Regelungsverhalten in Bezug auf vorgegebene Ereignisse. Außerdem kann der Entwurf für das Steuerungsmodell beispielsweise eine Steuerungs- bzw. Regelungsfunktion und Steuerungs- bzw. Regelungsparameter umfassen.

Der erzeugte Entwurf wird erfindungsgemäß mittels eines künstlichen neuronalen Diskriminator-Netzwerks auf Übereinstimmung der Steuerungselemente mit der vorgegebenen Verteilung bzw. Zusammensetzung bewertet. Vorzugsweise sind das Generator-Netzwerk und das Diskriminator-Netzwerk Bestandteile eines Generative Adversarial Network (GAN). Erfindungsgemäß wird der Entwurf iterativ entsprechend der Übereinstimmung der Steuerungselemente mit der vorgegebenen Verteilung bzw. Zusammensetzung angepasst und erneut bewertet. Auf eine Benutzerfreigabe des Entwurfs wird ein das Steuerungsmodell implementierendes Steuerungs- bzw. Regelungsprogramm erzeugt.

Die vorliegende Erfindung ermöglicht ein KI-basiertes Engineering von sicherheitskritischen Steuerungsanwendungen für industrielle Automatisierungssysteme. Insbesondere können mittels der vorliegenden Erfindung erzeugte Steuerungs- bzw. Regelungsprogramme aufgrund der analytisch beschreibbaren Verteilung bzw. Zusammensetzung der Steuerungselemente des Steuerungsmodells leicht durch Bedienpersonal interpretiert und validiert werden. Daher kann in das erfindungsgemäße Verfahren ein entsprechender Validierungsschritt integriert werden, der speziell für sicherheitskritische Steuerungsanwendungen wichtig ist. Eine besonders gute Interpretierbarkeit bzw. Validierbarkeit ergibt sich bei Verwendung eines Generative Adversarial Network zur automatisierten Codeerstellung.

Entsprechend einer vorteilhaften Weiterbildung der vorliegenden Erfindung wird auf eine Benutzerzurückweisung des Entwurfs ein neuer Entwurf für das Steuerungsmodell unter Vorgabe geänderter Randbedingungen mittels des Generator-Netzwerks erzeugt. Der neue Entwurf wird wiederum mittels des Diskriminator-Netzwerks auf Übereinstimmung der Steuerungselemente mit der vorgegebenen Verteilung bzw. Zusammensetzung bewertet. Dabei kann der neue Entwurf iterativ entsprechend der Übereinstimmung der Steuerungselemente mit der vorgegebenen Verteilung bzw. Zusammensetzung angepasst und erneut bewertet werden. Vorzugsweise wird der Entwurf für das Steuerungsmodell nach seiner abschließenden Bewertung mittels des Diskriminator-Netzwerks für die Benutzerfreigabe oder die Benutzerzurückweisung an einer graphischen Benutzerschnittstelle dargestellt. Damit kann die Benutzerfreigabe oder die Benutzerzurückweisung unter Vorgabe der geänderten Randbedingungen entsprechend einer Benutzereingabe an der graphischen Benutzerschnittstelle erfolgen.

Die Steuerungselemente des Entwurfs für das Steuerungsmodell umfassen vorzugsweise Fuzzy-Mengen (Fuzzy Sets) für Prozesseingangsgrößen, eine Regelbasis und für Prozessausgangsgrößen anzuwendende Defuzzifizierungsmethoden. Dementsprechend kann mittels des Generator-Netzwerks ein Entwurf für ein Fuzzylogik-basiertes Steuerungsmodell erzeugt werden. Dabei umfasst das Fuzzylogik-basierte Steuerungsmodell die Fuzzy-Mengen, die Regelbasis und die Defuzzifizierungsmethoden als Steuerungselemente. Diese Steuerungselemente entsprechen einer analytisch beschreibbaren, vorgegebenen Verteilung bzw. Zusammensetzung und lassen sich besonders gut durch Menschen interpretieren bzw. validieren.

Entsprechend einer weiteren bevorzugten Ausgestaltung der vorliegenden Erfindung wird das Generator-Netzwerk auf Basis der Spezifikation des zu steuernden bzw. regelnden technischen Prozesses und mittels bekannter bzw. synthetisierter Steuerungslösungskomponenten für den zu steuernden technischen Prozess trainiert. Dabei umfassen die Steuerungslösungskomponenten insbesondere zumindest Eingangsdaten eines Engineering-Prozesses für einen Fuzzy-Regler. Auf diese Weise kann das Generator-Netzwerk effizient trainiert und gleichzeitig ein einfach interpretierbares Steuerungsmodell abgeleitet werden.

Das erfindungsgemäße System zur Erzeugung von Steuerungs- oder Regelungsprogrammen für industrielle Automatisierungsgeräte ist zur Durchführung eines Verfahrens entsprechend vorangehenden Ausführungen vorgesehen und umfasst einen Datenspeicher, in dem eine Spezifikation eines mittels zumindest eines Automatisierungsgeräts zu steuernden oder regelnden technischen Prozesses und vorgegebene Randbedingungen zur Steuerung oder Regelung des technischen Prozesses gespeichert sind. Außerdem umfasst das System ein künstliches neuronales Generator-Netzwerk, das dafür ausgestaltet und eingerichtet ist, auf Basis der Spezifikation des zu steuernden oder regelnden technischen Prozesses und auf Basis der vorgegebenen Randbedingungen einen Entwurf für ein Steuerungsmodell zu erzeugen. Dabei entsprechen Steuerungselemente des Steuerungsmodells einer analytisch beschreibbaren, vorgegebenen Verteilung bzw. Zusammensetzung.

Außerdem umfasst das erfindungsgemäße System ein künstliches neuronales Diskriminator-Netzwerk, das dafür ausgestaltet und eingerichtet ist, den erzeugten Entwurf auf Übereinstimmung der Steuerungselemente mit der vorgegebenen Verteilung bzw. Zusammensetzung zu bewerten. Zusätzlich ist eine Ablaufsteuerungsvorrichtung vorgesehen, die dafür ausgestaltet und eingerichtet ist, dass der Entwurf iterativ entsprechend der Übereinstimmung der Steuerungselemente mit der vorgegebenen Verteilung bzw. Zusammensetzung angepasst und erneut bewertet wird. Darüber hinaus umfasst das System einen Programmcode-Generator, der dafür ausgestaltet und eingerichtet ist, dass auf eine Benutzerfreigabe des Entwurfs ein das Steuerungsmodell implementierendes Steuerungs- oder Regelungsprogramm erzeugt wird.

Die vorliegende Erfindung wird nachfolgend an einem Ausführungsbeispiel anhand der Zeichnung näher erläutert. Es zeigt
- Figur 1: eine Übersicht über wesentliche Schritte eines konventionellen, eines KI-basierten und eines validierbaren, KI-basierten Engineering-Prozesses zur Erzeugung von Steuerungs- oder Regelungsprogrammen,
- Figur 2: eine Darstellung eines Verfahrensablaufs einer automatisierten Erstellung eines Regelungs- bzw. Steuerungsprogramms für einen Fuzzy Controller,
- Figur 3: eine schematische Darstellung eines Systems für eine automatisierte, validierbare Erstellung eines Regelungs- bzw. Steuerungsprogramms.

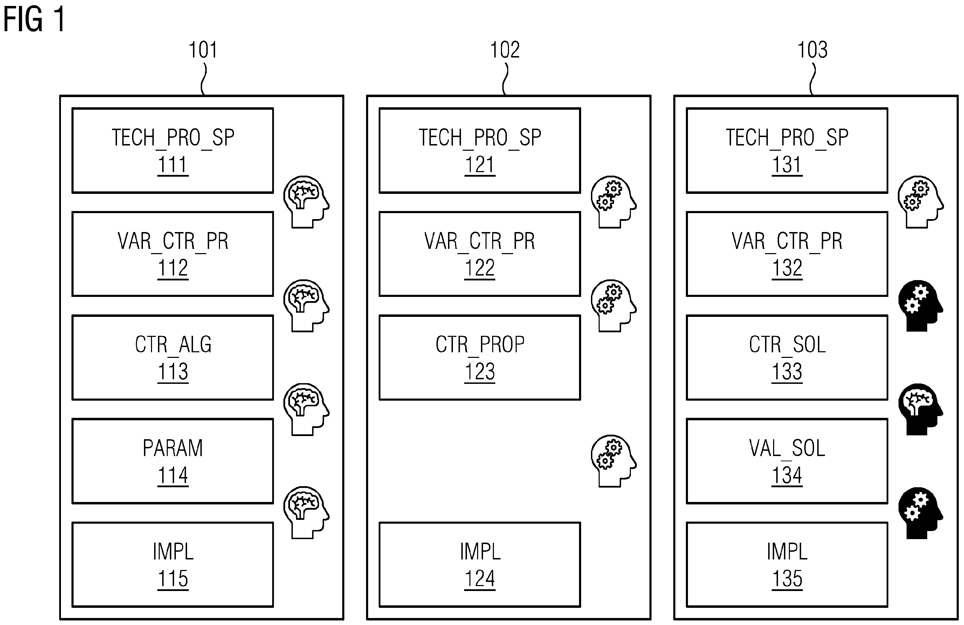

In Figur 1 sind wesentliche Schritte eines konventionellen, eines KI-basierten und eines validierbaren, KI-basierten Engineering-Prozesses zur Erzeugung von Steuerungs- oder Regelungsprogrammen gegenübergestellt. Beim konventionellen Engineering-Prozess 101 erfolgt zunächst eine Spezifikation eines mittels eines Automatisierungsgeräts zu steuernden bzw. regelnden technischen Prozesses (Schritt 111) und eine Festlegung von Eingangs- und Ausgangsvariablen sowie von Randbedingungen zur Steuerung bzw. Regelung des technischen Prozesses (Schritt 112). Diese beiden Schritte 111-112 finden auch beim KI-basierten Engineering-Prozess 102 (Schritt 121-122) und beim validierbaren, KI-basierten Engineering-Prozess 103 (Schritt 131-132) ihre direkten Entsprechungen.

Entsprechend Schritt 113 des konventionellen Engineering-Prozess 101 wird eine Regelungskreisstruktur gewählt und ein Regelungsalgorithmus festgelegt. Anschließend werden in Schritt 114 Regelungsparameter ermittelt. Auf Basis dieser Ergebnisse wird entsprechend Schritt 115 eine Implementierung in Form eines Steuerungs- bzw. Regelungsprogramms erstellt. Demgegenüber wird beim KI-basierten Engineering-Prozess 102 in Schritt 123 nach der Spezifikation des zu steuernden bzw. regelnden technischen Prozesses (Schritt 121) und der Festlegung der Eingangs- und Ausgangsvariablen sowie der Randbedingungen (Schritt 122) auf Basis von anwendungsspezifischen Trainingsdaten automatisch ein Vorschlag für eine Steuerungs- bzw. Regelungslösung erstellt, beispielsweise in Form eines linearen oder nichtlinearen Kennfeldreglers. Abschließend wird dieser Vorschlag beim KI-basierten Engineering-Prozess 102 für eine Implementierung durch ein Steuerungs- bzw. Regelungsprogramm genutzt (Schritt 124).

Im Unterschied zum KI-basierten Engineering-Prozess 102 wird beim validierbaren, KI-basierten Engineering-Prozess 103 nach der Spezifikation des zu steuernden bzw. regelnden technischen Prozesses (Schritt 131) und der Festlegung der Eingangs- und Ausgangsvariablen sowie der Randbedingungen (Schritt 132) in Schritt 133 ein durch Menschen validierbarer Vorschlag für eine Steuerungs- bzw. Regelungslösung erstellt, und zwar auf Basis von anwendungsspezifischen Trainingsdaten. Dieser Vorschlag wird anschließend in Schritt 134 durch Bedienpersonal bzw. Benutzer-seitig validiert. Erst ein entsprechend validierter Vorschlag bildet eine Grundlage eine Implementierung in Form eines Steuerungs- bzw. Regelungsprogramms (Schritt 135).

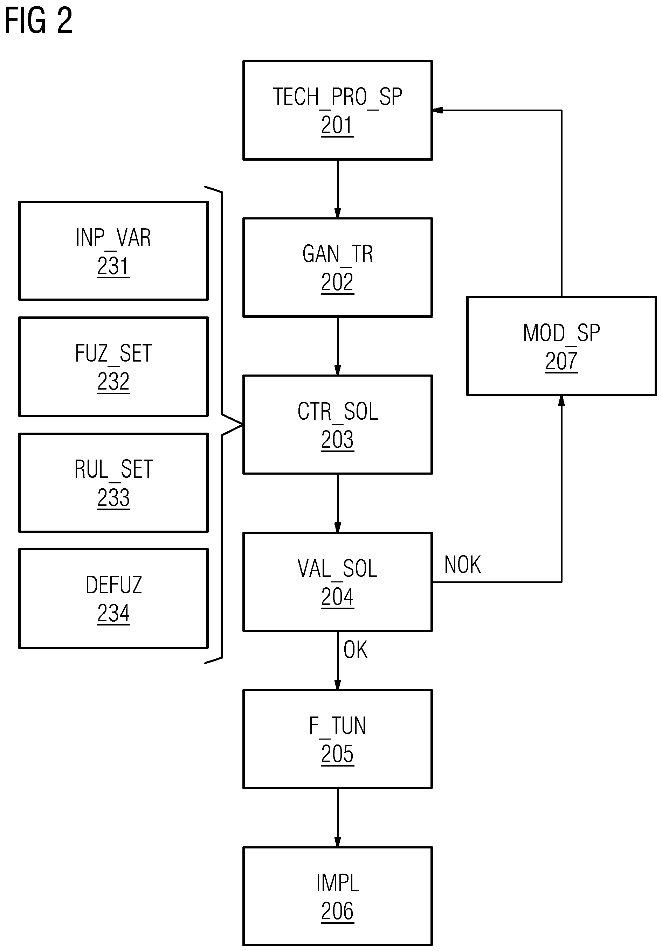

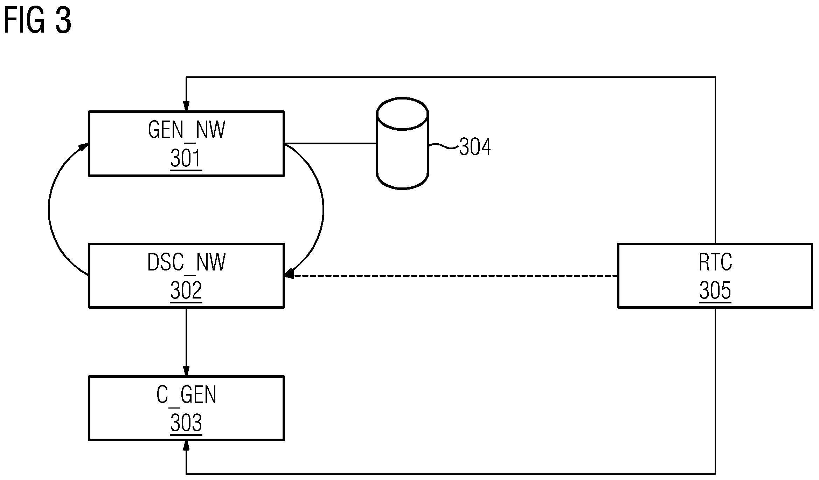

Der validierbare, KI-basierte Engineering-Prozess wird anhand von Figur 2 hinsichtlich einer automatisierten Erstellung eines Regelungs- bzw. Steuerungsprogramms für einen Fuzzy Controller näher erläutert. Entsprechend obigen Ausführungen werden zunächst eine Spezifikation eines mittels eines Automatisierungsgeräts zu steuernden bzw. regelnden technischen Prozesses erstellt und Randbedingungen zur Steuerung bzw. Regelung des technischen Prozesses festgelegt (Schritt 201). Diese Ergebnisse können beispielsweise für eine spätere Verwendung in einem Datenspeicher 304 des in Figur 3 dargestellten Systems gespeichert werden. Die Spezifikation des zu steuernden bzw. regelnden technischen Prozesses umfasst insbesondere ein Prozessmodell. Die Randbedingungen zur Steuerung bzw. Regelung des technischen Prozesses umfassen im vorliegenden Ausführungsbeispiel Prozesseingangsgrößen, Prozessausgangsgrößen sowie ein gewünschtes Steuerungs- bzw. Regelungsverhalten in Bezug auf vorgegebene Ereignisse.

Auf Basis der Spezifikation des zu steuernden bzw. regelnden technischen Prozesses und der Randbedingungen wird mittels eines künstlichen neuronalen Generator-Netzwerks 301 entsprechend Schritt 202 ein Entwurf für ein Steuerungsmodell erzeugt, dessen Steuerungselemente einer analytisch beschreibbaren, vorgegebenen Verteilung bzw. Zusammensetzung entsprechen. Der Entwurf für das Steuerungsmodell umfasst insbesondere eine Steuerungs- bzw. Regelungsfunktion und Steuerungs- bzw. Regelungsparameter. Vorzugsweise wird das Generator-Netzwerk 301 auf Basis der Spezifikation des zu steuernden bzw. regelnden technischen Prozesses und mittels bekannter bzw. synthetisierter Steuerungslösungskomponenten für den zu steuernden technischen Prozess trainiert. Im vorliegenden Ausführungsbeispiel umfassen die Steuerungslösungskomponenten Eingangsdaten eines Engineering-Prozesses für einen Fuzzy Controller. Dementsprechend wird mittels des Generator-Netzwerks 301 ein Entwurf für ein Fuzzy Logic-basiertes Steuerungsmodell erzeugt.

Darüber hinaus weist das in Figur 3 darstellte System für eine automatisierte, validierbare Erstellung von Regelungs- bzw. Steuerungsprogrammen ein künstliches neuronales Diskriminator-Netzwerk 302 auf, das dafür konfiguriert ist, den erzeugten Entwurf auf Übereinstimmung der Steuerungselemente mit der vorgegebenen Verteilung bzw. Zusammensetzung zu bewerten. Dies ist Teil der Erzeugung des Entwurfs für das Steuerungsmodell entsprechend Schritt 202. Insbesondere sind das Generator-Netzwerk 301 und das Diskriminator-Netzwerk 302 dabei Bestandteile eines Generative Adversarial Network (GAN).

Üblicherweise bildet ein Generator-Netzwerk 301 von einem Vektor aus latente Variablen auf einen gewünschten Ergebnisraum ab. Aufgabe des Generator-Netzwerks 301 ist es, zu lernen, Ergebnisse nach einer bestimmten Verteilung zu erzeugen. Im vorliegenden Ausführungsbeispiel ist diese Verteilung durch eine Gestaltung von Fuzzy Control Sets für Eingangs- und Ausgangsvariablen des entwerfenden Fuzzy Controllers bestimmt. Das Diskriminator-Netzwerk 302 wird demgegenüber darauf trainiert, die Ergebnisse des Generator-Netzwerks 301 von Daten aus einer realen, vorgegebenen Verteilung zu unterscheiden. Ziel des Generator-Netzwerks 301 ist es daher, Ergebnisse zu erzeugen, die das Diskriminator-Netzwerk 302 nicht von der realen, vorgegebenen Verteilung unterscheiden kann. Auf diese Weise gleicht die erzeugte Verteilung nach und nach an die reale, vorgegebene Verteilung an. Mittels einer Ablaufsteuerungsvorrichtung 305 des in Figur 3 dargestellten Systems wird der Entwurf für das für das Steuerungsmodell iterativ entsprechend der Übereinstimmung der Steuerungselemente mit der vorgegebenen Verteilung bzw. Zusammensetzung angepasst und ggf. erneut bewertet.

Nach Abschluss der Erzeugung des Entwurfs für das Fuzzy Logic-basierte Steuerungsmodell (Schritt 202) wird dieser entsprechend Schritt 203 an einer graphischen Benutzerschnittstelle zur Validierung durch Bedienpersonal dargestellt. Dabei umfassen die Steuerungselemente des Entwurfs für das Steuerungsmodell Eingangsvariablen 231 für Prozesseingangsgrößen, Fuzzy Control Sets 232 für die Prozesseingangsgrößen, eine Regelbasis 233 und für Prozessausgangsgrößen anzuwendende Defuzzifizierungsmethoden 234. Dabei entsprechen diese Steuerungselemente einer analytisch beschreibbaren, vorgegebenen Verteilung bzw. Zusammensetzung und somit damit durch Menschen leicht interpretierbar bzw. validierbar.

Entsprechend Schritt 204 des in Figur 2 dargestellten Verfahrensablaufs wird der Entwurf für das Fuzzy Logic-basierte Steuerungsmodell durch Bedienpersonal bzw. Benutzer-seitig validiert. Auf eine Benutzerfreigabe des Entwurfs kann entsprechend Schritt 205 noch ein Fein-Tuning am Entwurf durch Bedienpersonal vorgenommen werden, bevor in Schritt 206 eine Implementierung des Entwurfs für das Fuzzy Logic-basierte Steuerungsmodell erfolgt. Hierzu ist ein Programmcode-Generator 303 des in Figur 3 dargestellten Systems vorgesehen. Der Programmcode-Generator 303 ist dafür konfiguriert, dass auf eine Benutzerfreigabe des Entwurfs und ein ggf. anschließendes Fein-Tuning ein das Steuerungsmodell implementierendes Steuerungs- bzw. Regelungsprogramm erzeugt wird.

Auf eine Benutzerzurückweisung des Entwurfs kann ein neuer Entwurf für das Steuerungsmodell unter Vorgabe geänderter Randbedingungen mittels des Generator-Netzwerks erzeugt werden. Hierzu erfolgt entsprechend Schritt 207 eine Spezifizierung geänderter Randbedingungen für den neuen Entwurf. Der neue Entwurf wird wiederum mittels des Generator-Netzwerks 301 erstellt und mittels des Diskriminator-Netzwerks 302 auf Übereinstimmung der Steuerungselemente mit der vorgegebenen Verteilung bzw. Zusammensetzung bewertet (siehe Schritt 202). Somit kann der neue Entwurf iterativ entsprechend der Übereinstimmung der Steuerungselemente mit der vorgegebenen Verteilung bzw. Zusammensetzung angepasst und erneut bewertet werden.

Insgesamt wird der Entwurf für das Steuerungsmodell nach seiner abschließenden Bewertung mittels des Diskriminator-Netzwerks 302 für die Benutzerfreigabe oder die Benutzerzurückweisung an einer graphischen Benutzerschnittstelle dargestellt. Sowohl die Benutzerfreigabe als auch die Benutzerzurückweisung unter Vorgabe der geänderten Randbedingungen erfolgt entsprechend einer Benutzereingabe an der graphischen Benutzerschnittstelle.

Die Anwendung der vorliegenden Erfindung ist nicht auf eine automatische Programmcode-Generierung für Fuzzy Controller beschränkt. Vielmehr ist die vorliegende Erfindung auch mit anderen, einfach für Menschen interpretierbaren Low-Code-Lösungen, beispielsweise Mendix, Scratch, Blockly oder Turtle, gut nutzbar.

## Patentansprüche

1. Verfahren zur Erzeugung von Steuerungs- oder Regelungsprogrammen für industrielle Automatisierungsgeräte, bei dem
- auf Basis einer Spezifikation eines mittels zumindest eines Automatisierungsgeräts zu steuernden oder regelnden technischen Prozesses und auf Basis von vorgegebenen Randbedingungen zur Steuerung oder Regelung des technischen Prozesses mittels eines künstlichen neuronalen Generator-Netzwerks (301) ein Entwurf für ein Steuerungsmodell erzeugt wird (133, 202), dessen Steuerungselemente einer analytisch beschreibbaren, vorgegebenen Verteilung und/oder Zusammensetzung entsprechen,
- der erzeugte Entwurf mittels eines künstlichen neuronalen Diskriminator-Netzwerks (302) auf Übereinstimmung der Steuerungselemente mit der vorgegebenen Verteilung und/oder Zusammensetzung bewertet wird,
- der Entwurf iterativ entsprechend der Übereinstimmung der Steuerungselemente mit der vorgegebenen Verteilung und/oder Zusammensetzung angepasst und erneut bewertet wird (134, 204),
- auf eine Benutzerfreigabe des Entwurfs ein das Steuerungsmodell implementierendes Steuerungs- oder Regelungsprogramm erzeugt wird (135, 206).

2. Verfahren nach Anspruch 1,
bei dem auf eine Benutzerzurückweisung des Entwurfs ein neuer Entwurf für das Steuerungsmodell unter Vorgabe geänderter Randbedingungen mittels des Generator-Netzwerks (301) erzeugt wird und bei dem der neue Entwurf mittels des Diskriminator-Netzwerks (302) auf Übereinstimmung der Steuerungselemente mit der vorgegebenen Verteilung und/oder Zusammensetzung bewertet wird.

3. Verfahren nach Anspruch 2,
bei dem der neue Entwurf iterativ entsprechend der Übereinstimmung der Steuerungselemente mit der vorgegebenen Verteilung und/oder Zusammensetzung angepasst und erneut bewertet wird.

4. Verfahren nach einem der Ansprüche 2 oder 3,
bei dem der Entwurf für das Steuerungsmodell nach seiner abschließenden Bewertung mittels des Diskriminator-Netzwerks für die Benutzerfreigabe oder die Benutzerzurückweisung an einer graphischen Benutzerschnittstelle dargestellt wird und bei dem die Benutzerfreigabe oder die Benutzerzurückweisung unter Vorgabe der geänderten Randbedingungen entsprechend einer Benutzereingabe an der graphischen Benutzerschnittstelle erfolgt.

5. Verfahren nach einem der Ansprüche 1 bis 4,
bei dem das Generator-Netzwerk auf Basis der Spezifikation des zu steuernden oder regelnden technischen Prozesses und mittels bekannter und/oder synthetisierter Steuerungslösungskomponenten für den zu steuernden technischen Prozess trainiert wird.

6. Verfahren nach Anspruch 5,
bei dem die Steuerungslösungskomponenten zumindest Eingangsdaten eines Engineering-Prozesses für einen Fuzzy-Regler umfassen.

7. Verfahren nach einem der Ansprüche 1 bis 6,
bei dem die Spezifikation des zu steuernden oder regelnden technischen Prozesses ein Prozessmodell umfasst.

8. Verfahren nach einem der Ansprüche 1 bis 7,
bei dem die vorgegebenen Randbedingungen zur Steuerung oder Regelung des technischen Prozesses Prozesseingangsgrößen, Prozessausgangsgrößen und ein gewünschtes Steuerungs- oder Regelungsverhalten in Bezug auf vorgegebene Ereignisse umfassen.

9. Verfahren nach einem der Ansprüche 1 bis 8,
bei dem der Entwurf für das Steuerungsmodell eine Steuerungs- oder Regelungsfunktion und Steuerungs- oder Regelungsparameter umfasst.

10. Verfahren nach einem der Ansprüche 1 bis 9,
bei dem die Steuerungselemente des Entwurfs für das Steuerungsmodell Fuzzy-Mengen (232) für Prozesseingangsgrößen (231), eine Regelbasis (233) und für Prozessausgangsgrößen anzuwendende Defuzzifizierungsmethoden (234) umfassen.

11. Verfahren nach Anspruch 10,
bei dem mittels des Generator-Netzwerks (301) ein Entwurf für ein Fuzzylogik-basiertes Steuerungsmodell erzeugt wird und bei dem das Fuzzylogik-basierte Steuerungsmodell die Fuzzy-Mengen (232), die Regelbasis (233) und die Defuzzifizierungsmethoden (234) als Steuerungselemente umfasst, die einer analytisch beschreibbaren, vorgegebenen Verteilung und/oder Zusammensetzung entsprechen.

12. Verfahren nach einem der Ansprüche 1 bis 11,
bei dem das Generator-Netzwerk (301) und das Diskriminator-Netzwerk (302) Bestandteile eines Generative Adversarial Network sind.

13. System zur Erzeugung von Steuerungs- oder Regelungsprogrammen für industrielle Automatisierungsgeräte mit
- einem Datenspeicher (304), in dem eine Spezifikation eines mittels zumindest eines Automatisierungsgeräts zu steuernden oder regelnden technischen Prozesses und vorgegebene Randbedingungen zur Steuerung oder Regelung des technischen Prozesses gespeichert sind,
- einem künstlichen neuronalen Generator-Netzwerk (301), das dafür ausgestaltet und eingerichtet ist, auf Basis der Spezifikation des zu steuernden oder regelnden technischen Prozesses und auf Basis der vorgegebenen Randbedingungen einen Entwurf für ein Steuerungsmodell zu erzeugen (133, 202), dessen Steuerungselemente einer analytisch beschreibbaren, vorgegebenen Verteilung und/oder Zusammensetzung entsprechen,
- einem künstlichen neuronalen Diskriminator-Netzwerk (302), das dafür ausgestaltet und eingerichtet ist, den erzeugten Entwurf auf Übereinstimmung der Steuerungselemente mit der vorgegebenen Verteilung und/oder Zusammensetzung zu bewerten,
- einer Ablaufsteuerungsvorrichtung (305), die dafür ausgestaltet und eingerichtet ist, dass der Entwurf iterativ entsprechend der Übereinstimmung der Steuerungselemente mit der vorgegebenen Verteilung und/oder Zusammensetzung angepasst und erneut bewertet wird (134, 204),
- einem Programmcode-Generator (303), der die dafür ausgestaltet und eingerichtet ist, dass auf eine Benutzerfreigabe des Entwurfs ein das Steuerungsmodell implementierendes Steuerungs- oder Regelungsprogramm erzeugt wird (135, 206).
